Europäisches Patentamt

European Patent Office

Office européen des brevets

(11) Publication number: **0 150 089**
**A1**

## (12) EUROPEAN PATENT APPLICATION

(21) Application number: **85300210.3**

(22) Date of filing: **11.01.85**

(51) Int. Cl.⁴: **H 01 J 37/10**
**H 01 J 27/00**

(30) Priority: **19.01.84 GB 8401578**

(43) Date of publication of application:
**31.07.85 Bulletin 85/31**

(84) Designated Contracting States:
**AT BE CH DE FR GB IT LI LU NL SE**

(71) Applicant: **DUBILIER PLC**
**Dubilier House Radley Road**
**Abingdon Oxford OX14 3XA(GB)**

(72) Inventor: **Cleaver, John Richard Adrian Dept. of**
**Engineering**
**Cambridge University Trumpington Street**
**Cambridge CB2 1PZ(GB)**

(72) Inventor: **Ahmed, Haroon Dept. of Engineering**
**Cambridge University Trumpington Street**
**Cambridge CB2 1PZ(GB)**

(74) Representative: **Boydell, John Christopher et al,**
**Stevens, Hewlett & Perkins 5 Quality Court Chancery**
**Lane**
**London, WC2A 1HZ(GB)**

(54) **Charged-particle optical systems.**

(57) An objective lens for focusing electron and ion beams onto a target plane 31. The lens has an electrostatic portion and a magnetic portion: the electrostatic portion takes the form of a three-element einzel lens having outer electrodes 11, 12 commoned by a shell 10 and cover 9 and connected to ground and an inner electrode 15 at a high voltage, said electrode 15 being mounted on shell 10 by an insulator 16. Electrodes 11, 12 shell 10 and cover 9 are all made of ferromagetic material excited by a current carrying coil 13. Electrodes 11, 12 thus double as polepieces for the magnetic portion of the lens. By suitable adjustment of the electric and magnetic field strengths, the ion and electron beams can both be brought to a focus on the target plane 31.

FIG.3

EP 0 150 089 A1

## "CHARGED-PARTICLE OPTICAL SYSTEMS"

This invention relates to charged-particle optical systems for the production of finely-focused beams of both electrons and ions.

Scanning electron beam instruments, in which a finely-focused beam of electrons is deflected across a target for the purpose either of forming an image of it or of modifying it, are well established. The earliest instrument in this category was the scanning electron microscope, which can form images from the surface of solid specimens (see Smith and Oatley, 1955 Brit. J. Appl. Phys. 6, 391-399) or in transmission from thin specimens (see Crewe et al., 1968 J. Appl. Phys. 39, 5861-5868). Solid specimens can be imaged with resolution better than 5 nm, and transmission specimens better than 0.5 nm. From the microscopes have evolved scanning electron beam microfabrication instruments, used for producing patterns for microelectronic device fabrication. In these instruments the finely focused electron beam is deflected under computer control over an electron-sensitive resist layer deposited on the surface either of a mask plate or of a partially-fabricated semiconductor device wafer to enable the resist layer subsequently to be selectively dissolved, forming a pattern that defines the areas to be subjected to a subsequent process such as etching or ion implantation.

It is possible to construct a similar range of instruments which use ion beams rather than electron beams. However, traditional gas-discharge ion sources are too large and produce too small a current density for use as a basis for scanning ion beam systems with focused beams of comparable diameters and currents to those available in electron beam systems. The recently invented liquid-metal field-ionisation source (see Clampitt et al., 1975 J. Vac. Sci. Technol. 12, 1208), which has relatively a very small size and high brightness, has made possible the production of sub-micron diameter ion beams that can transport useful ion currents.    The resultant scanning ion beam systems can, like electron beams, be used both for imaging and for microfabrication; the scanning ion microscope (see Cleaver, 1983 EMAG 83 Inst. Phys. Conf. Ser.) can perform imaging in modes not available in the electron microscope (see Levi-Setti et al., 1983 Nucl. Instrum. and Meth. 205, 299-309), whilst scanning ion beam lithography instruments can not only pattern resist layers but can also be used for direct maskless ion implantation of dopants and for micromachining operations (see Cleaver et al., 1983 "Microcircuit Engineering 83", Academic Press; and Wagner, 1983 Solid State Technol., May 1983, 97-103).

Both in microscopes and in microcircuit fabrication instruments it is advantageous for finely focused beams of both ions and electrons to be present either simultaneously or in rapid sequence.    In microscopes comparisons can be made between the information derived in various image formation modes using the scanned electron and ion beams, whilst in microcircuit fabrication the two focused beams can be used for different aspects of processing, for example using the scanned electron beam to detect fiducial marks for pattern registration and then using the ion beam for implantation or micromachining.    For these purposes it is necessary to form sub-micron diameter beams of ions and electrons lying, in the absence of deflection scanning signals, on the same axis.    Electrons can be focused with either electrostatic or magnetic lenses, but the relatively large mass-to-charge ratio of ions necessitates the use of electrostatic lenses.    Objective lenses (the final lenses which form the finely focused beams at the target) need to have short working distances of only a few millimetres, in order to achieve good optical performance, and thus it is not practicable to consider having two lenses with different oblique axes converging onto the target. Oblique incidence would also introduce very severe problems in matching the scan fields covered by the deflected ion and electron beams.

Therefore a combined beam system requires coaxial objective lenses for the ions and for the electrons. The present invention seeks to provide such a system.

In accordance with the invention there is provided a charged-particle optical system for the production of finely-focused beams of both electrons and ions, said system comprising a source of electrons, a source of ions and an objective lens comprising first means including at least two electrodes for applying to the beam an electric field, and second means including one or more polepieces for applying to the beam a magnetic field, the electric and magnetic fields being adjusted in such a way as to cause the lens to focus both the ion and electron beams onto a common target plane coincident with the target.

The lens electrode potentials are chosen so that the electric field brings the ions to a focus close to the target plane, whilst its focusing effect on the electrons is less strong. The lens polepieces provide a further magnetic focusing field that predominantly affects the electrons, providing a substantial supplementary focusing effect for the electrons whilst having only a very small effect on the ions. By proper adjustment of the fields the focal planes for both the electrons and the ions are made coincident at the target plane.

In one embodiment the electric field is produced by three or more electrodes, of which the outermost are at the same electric potential (commonly, but not necessarily, ground potential) so that both ions and electrons emerge from the lens with energies unchanged from their values at incidence. An example of this kind of lens is the three-electrode einzel lens, with central electrode potential chosen so that ions are decelerated on entering the lens and subsequently accelerated back to their initial potential whilst electrons are accelerated and then decelerated. If the magnitudes of the potential differences through which the ions and the electrons are accelerated prior to entering the lens are similar, this configuration meets the requirement for an electric lens stronger for ions than for electrons.

In an alternative embodiment the electric field is produced by three or more electrodes, with the outermost at different potentials so that there is net acceleration of one kind of particle and net deceleration of the other kind in passage through the lens. Within the lens the electrons are first accelerated and then decelerated and the ions are first decelerated and then accelerated, so producing a lens weaker for electrons than for ions. A degenerate form of this system would have two electrodes only, so that one kind of particle would be accelerated monotonically and the other decelerated monotonically.

In the preferred embodiments, the electrodes that determine the form of the electric field are made, wholly or in part, of ferromagnetic material so as to act also as polepieces to determine the form of the magnetic field. In one alternative, the magnetic focusing field is formed between two or more polepieces such that those polepieces connected to the ferromagnetic circuit that forms the return path for the magnetic flux are at the same potential. An example is the use of a three-element einzel lens with the outermost electrodes connected to the ferromagnetic circuit. Such an einzel lens can have either a ferromagnetic central electrode (so that the magnetic focusing field is concentrated into two regions situated where the electric field is also strong) or a non-magnetic central electrode (giving a longer, single magnetic focusing field).

In another alternative, the magnetic focusing field is formed between two or more polepieces such that those polepieces connected to the ferromagnetic circuit that forms the return path for the magnetic flux are at different potentials. In such a system it is necessary to introduce a gap or gaps into the ferromagnetic circuit to meet the requirement for high voltage isolation of the electrodes.

In a still further alternative, the magnetic focusing field is formed between two or more polepieces that together form one electrode.

In order that the invention may be better understood, several embodiments thereof will now be described by way of example only and with reference to the accompanying drawings in which:-

Figure 1A is a diagrammatic side view of a known three-element einzel lens;

Figure 1B shows graphically one possible variation of potential along the axis of the lens of Figure 1A;

Figure 1C is a diagram of the electron and ion trajectories E and I respectively through the lens of Figure 1A;

Figure 2A is a diagrammatic side view of a first embodiment of a lens for incorporation in the optical system of the present invention;

Figures 2B and 2C show respectively the electric and magnetic field strengths along the axis of the lens of Figure 2A;

Figure 2D is a diagram of the electron and ion trajectories E and I respectively through the lens of Figure 2A;

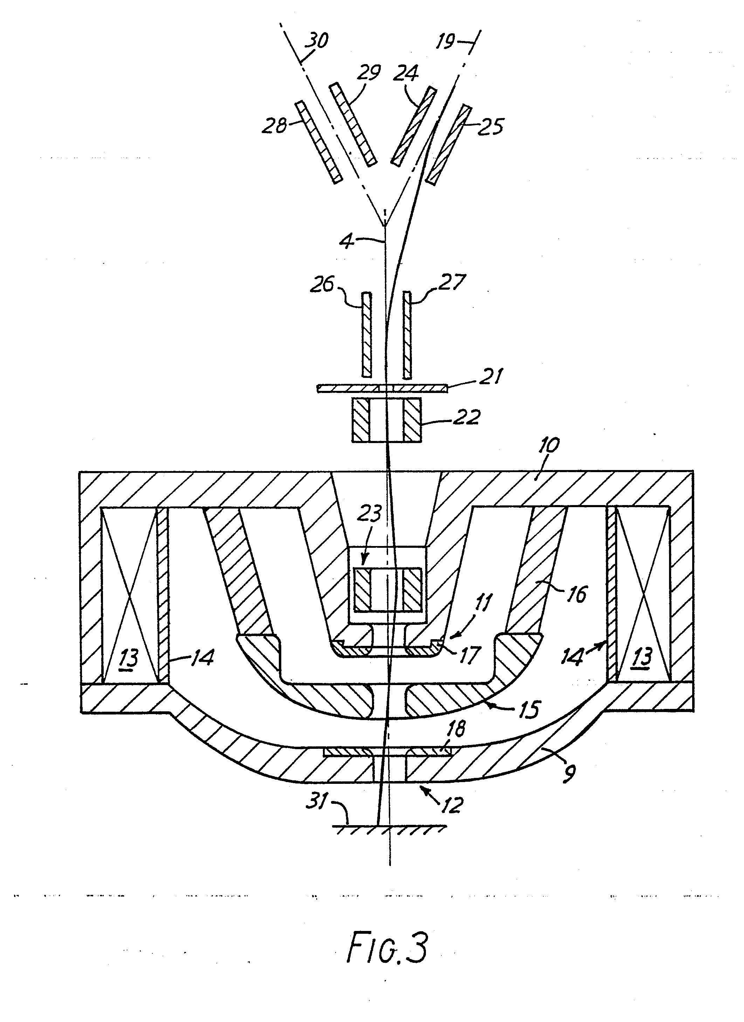

. Figure 3 is a diagrammatic side view of a second embodiment of a lens showing, in addition and by way of example, certain associated parts of the optical system;

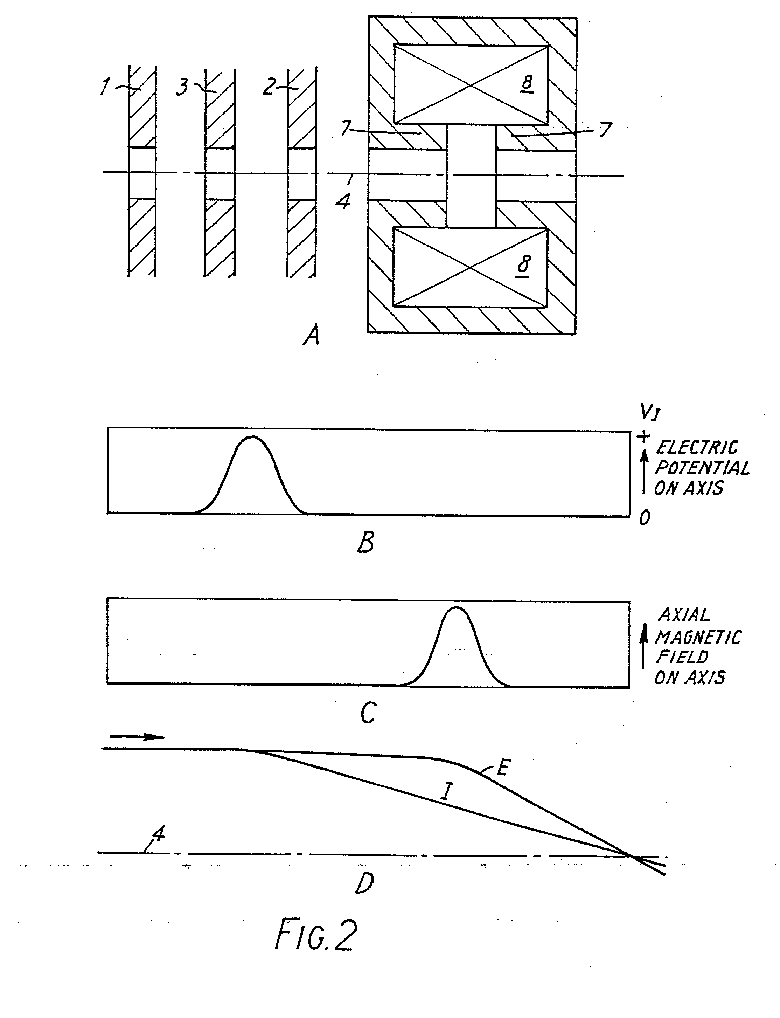

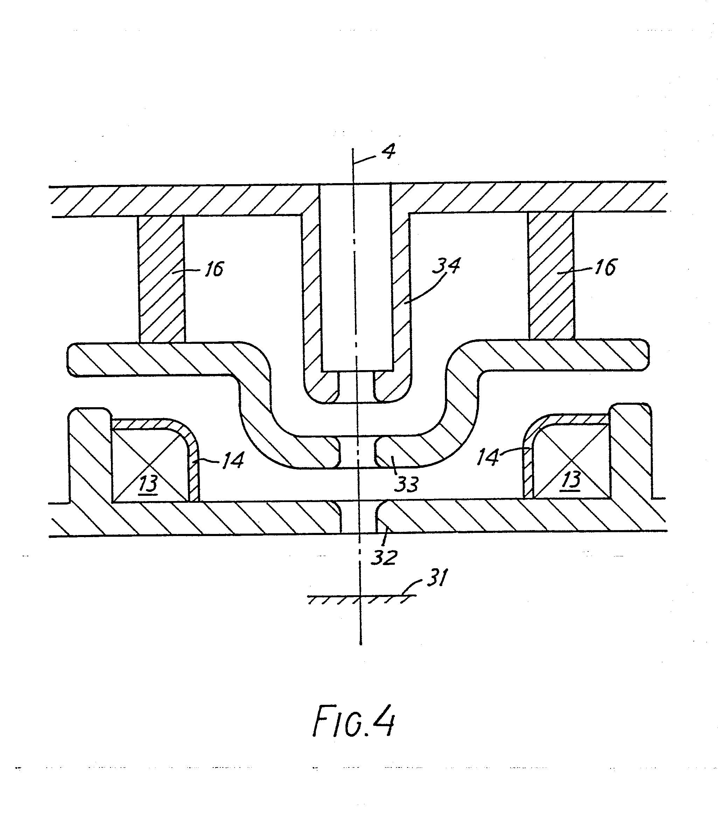

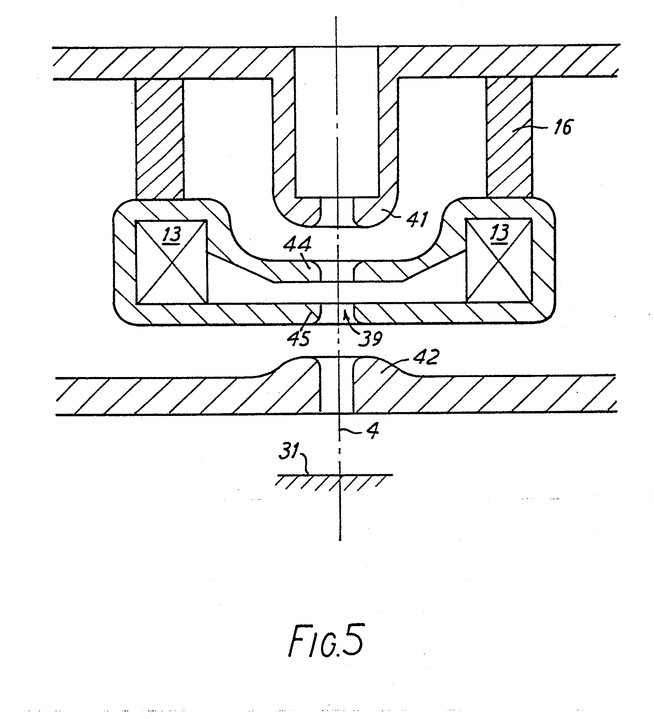

Figures 4 and 5 are similar to Figure 2A, and show third and fourth embodiments of the lens.

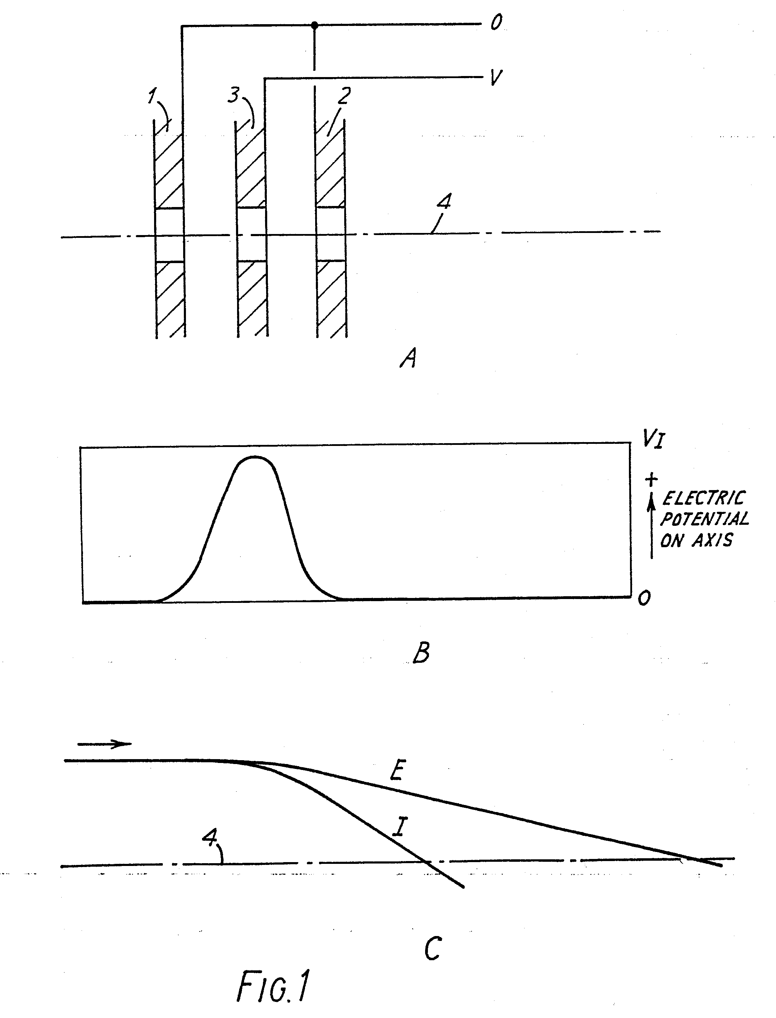

The three-element electrostatic einzel-lens shown in Figure 1A consists of two outer electrodes 1,2 at the same electric potential (normally ground potential) and an inner electrode 3 at an elevated potential V. All electrodes have round holes on the system axis 4, about which there is cylindrical symmetry. The lens can be operated in two modes: in one the central electrode is at a potential which lies between that of the outer electrodes and that of the source of charged particles (not shown) so that in passage through the lens they are initially decelerated and subsequently accelerated back to their initial velocity; in the other the outer electrodes are at a potential between that of the source and that of the central electrode (so that the particles are first accelerated and then decelerated). The potentials required for focusing are rather different in the two modes: in the initially-decelerating mode the particles are retarded by about 80% of the full beam potential whilst in the initially-accelerating mode they are accelerated by about 150% of the beam potential. A typical axial potential distribution for a lens used in the initially-decelerating mode for positive ions at potential $V_I$ is shown in Figure 1B, and the corresponding ion trajectory in Figure 1C.

If the same lens is used both for positive ions and for electrons, then for one set of particles it will act as an initially-accelerating lens whilst for the other set it will act as an initially-decelerating lens. If the ion and the electron beams have been accelerated through similar potential differences before reaching the lens, then the lens will have different focal lengths for the ions and for the electrons (for a parallel incident beam the initially-decelerated particles will be brought to a focus much closer to the lens than the initially-accelerated particles). This is illustrated in Figure 1C, where the electric lens field acts in the initially-decelerating mode for the ion beam and thus is a much weaker lens for electrons than for ions.

However, the electric field can be supplemented with a magnetic field (either superimposed or adjacent) which will focus the electrons whilst having little effect on the much heavier ions. A simple lens arrangement of this type is shown in Figure 2A. The electric lens portion has its outer electrodes 1,2 grounded and its central electrode 3 at a high positive potential similar to that of the ion source, producing the axial potential distribution of Figure 2B; the magnetic lens portion comprises a pair of ferromagnetic polepieces 7 and is excited by a current-carrying coil 8. The magnetic lens portion produces the axial magnetic field distribution of Figure 2C. If ion and electron beams that have been accelerated through similar potential differences are incident on the lens with trajectories parallel to the system axis 4, then the ions will be affected much more strongly than the electrons by the electric lens portion (since they will be decelerated initially); however, the relatively high mass-to-charge ratio of the ions will cause them to be only slightly affected by the magnetic field, whereas the electrons will be strongly focused. By suitable choice of electric and magnetic field strengths, the foci for the electrons and the ions can be made coincident. as shown in Figure 2D.

Several variants of this lens are possible. The simplest involves the use of completely independent elements to produce the electric and the magnetic fields, as shown in Figure 2A. This has the advantage of simplicity, but the disadvantage that the effective centre of the lens for the ions is far from the target; the aberrations are increased for the ions and the optical performance degraded. Wide separation of the lens centres complicates the operation of pre-lens double-deflection scan plate sets. Clearly the positions of the magnetic and the electrostatic fields can be reversed, but this degrades the optical performance for electrons. If good lens performance for both ions and electrons is not essential, then one of these configurations may be used.

Several arrangements of electric and magnetic fields that meet the basic requirements are described below. In the descriptions it is assumed that the axis of the objective lens is vertical, with the target below the lens. This accords with common (but not invariable) practice in electron beam and ion beam systems, and is adopted for convenience; it is not fundamental to operation. Nor is it fundamental that the outer electrodes in the electrostatic lens portion are at the same potential, that of ground. They may be at equal potentials, off ground potential; alternatively they may be at unequal potentials, so that there is net acceleration for particles with one charge polarity and net deceleration for the other. It is merely necessary that the electrostatic lens portion should be weaker for electrons than for ions, so that the shortfall in electrostatic lens strength for electrons can be made up by the magnetic lens portion. Additional electrodes can be introduced, or in a degenerate form of the system with unequal entry and exit potentials only two electrodes can be used. The magnetic lens portion may have one or more inter-polepiece gaps in the vicinity of the system axis 4, whilst auxiliary gaps may be introduced to provide high-voltage isolation between parts of the magnetic circuit.

Superposition of the electric and the magnetic fields is possible with the configurations of Figures 3, 4 and 5 to be described in detail below. Provided due account is taken of the needs for high-voltage insulation and for the provision of a complete and reasonably efficient magnetic circuit, it is possible to use the same elements as magnetic polepieces and as electrodes. Figure 3 shows an arrangement in which the two grounded electrodes of the einzel-lens portion are made from magnetic material and serve also as polepieces, in Figure 4 the central electrode and the lower grounded electrode serve as polepieces, whilst in Figure 5 the magnetic field is produced within the central electrode of the einzel-lens.

As well as showing the dual-function objective lens, Figure 3 also shows additional components to make up a complete optical system. These components will be referred to again later. The lens itself comprises an outer shell 10 which is grounded and has a cover 9 on its lower side. The shell and cover together define the outer electrodes 11 and 12 of a three element einzel-lens. The electrodes 11,12 serve also as polepieces for the magnetic lens portion. The shell 10, cover 9 and electrodes must therefore be made of materials with high relative permeability, such as soft iron (although, as shown, the polepieces can be capped with highly polished, non-magnetic electrode plates 17,18). The central electrode 15 of the einzel-lens can be made from either ferromagnetic or non-magnetic material, although the optical properties would be somewhat different in the two cases.   The central electrode is supported on a part-conical high-voltage insulator 16.   The magnetic polepieces are excited by a current carrying coil 13 which causes magnetic flux to flow in a circuit comprising the electrode 11, shell 10, cover 9, electrode 12, and across the gap between electrodes 11 and 12.   A grounded, non-magnetic shroud 14 is used to separate the magnetic lens coil 13 from the high-vacuum, high-voltage region.   This configuration has the advantage of a magnetic circuit with only a single gap and with ample space to accommodate the lens coil.   It has the disadvantage that the magnetic field has to be fairly long, to accommodate the two electric-field gaps and the central electrode, that the magnetic circuit is fairly large (increasing the magnetic flux leakage), and that space for the high-voltage insulator 16 is limited.

The configuration shown in Figure 4 utilises a lower outer electrode 32 and central electrode 33, both made of high permeability material, to form the magnetic circuit.   These are at substantially different potentials; thus the magnetic flux must pass across two gaps in the magnetic circuit, one the magnetic lens polepiece gap (where a magnetic field is required) and the other an auxiliary gap 38 in the magnetic flux return path which is provided for high-voltage isolation of the central electrode.   As before, the polepieces may be capped to make the electric field shape independent of the magnetic field shape.   The upper electrode 34 lies completely outside the magnetic field.   This configuration has the advantage of a compact magnetic circuit, but the disadvantage of two gaps and little space for the lens coil 13; a high current-density coil construction (see Mulvey, 1982 "Magnetic Electron Lenses", Springer-Verlag) can be employed.   The magnetic circuit does not restrict the space available for the high-voltage insulator 16. Use of the lower electrodes as polepieces has the optical advantage that the magnetic field can be placed close to the target plane shown under reference 31; it would also be possible to apply the magnetic field in the upper gap, but the magnetic field would then be less favourably placed.

A further variant is shown in Figure 5 in which the central electrode 39 is used as a miniature magnetic lens, and is made of high permeability material in such a way as to define a pair of magnetic polepieces 44,45 energisable by the current carrying coil 13. The outer electrodes 41,42 lie outside the magnetic field. Although this permits a compact magnetic circuit it has the practical disadvantage that the magnetic lens coil 13 is at high potential.

As mentioned above, Figure 3 shows the dual-function objective lens incorporated in a complete optical system. Above the lens upper electrode and polepiece 11 are electric scanning plates arranged in upper and lower plate sets 22,23 and each consisting of quadrupole or octopole electrode arrays. These act as a double-deflector to rock the charged-particle beams about the centre of the lens in order to deflect the beam at the target 31 whilst keeping the lens aberrations small. Above the deflector set is an aperture stop 21 that determines the current that will pass into the final lens, and above that is a deflecting prism system that can select either the ion or the electron beam to pass into the final lens. The ion and the electron beams that enter the prism are produced by optical columns (not shown) composed of conventional elements. For electrons a conventional triode thermionic gun can be used in combination with electrostatic or magnetic condenser lenses. The ion beam can be formed by a tetrode gun and electrostatic condenser lenses. Both upper columns would incorporate auxiliary electrode sets for beam alignment and stigmation, as well as aperture stops and other standard elements.

To select either the ion or the electron beam (or in some system variants to combine both beams for example sequentially or simultaneously) is used a prism system consisting of three pairs of electric deflector plates, one pair 24,25 on the axis of the incident ion beam 19, one pair on the axis 30 of the incident electron beam, and one pair 26,27 on the axis 4 of the emergent beam. The electric deflectors in the prism can be supplemented by magnetic fields, so that both the ion beam and the electron beam can be deflected simultaneously onto the axis of the objective lens.

If the electric double-deflector plates are supplemented by magnetic double-deflector coils, then it is possible to scan the ion and the electron beams independently over the target provided that electric and magnetic field strengths are set up in the correct ratios.

The optical system described above has a variety of applications, examples of which are given below:-

in microscopy and microanalysis, in which the ion and the electron beams can be scanned over the surface of the target in order to generate information about it by means including the liberation of secondary and Auger electrons, the liberation of secondary ions, the generation of photons of visible light or of x-rays;

in microscopy and microanalysis, in which the ion beam is used to modify the target by sputtering material away and so, for example, to reveal buried features for examination in a scanning mode with either the ion or the electron beam;

in applications where the target is the specimen in a transmission microscope configured so that the ion beam can be used to modify the specimen or to analyse it whilst the electron beam serves to illuminate the specimen for imaging by a series of post-specimen lenses;

in microcircuit fabrication, in which the different interactions between the ion and electron beams are utilised, for example, in which the ion beam is used to modify the target (by exposure of a resist layer, by ion implantation, by a sputtering process or a chemically-assisted micromachining process, or by other means) whilst the electron beam is used, for example, to detect registration marks that would not be detectable by the ion beam.

CLAIMS

1.      A charged-particle optical system for the production of finely-focused beams of both electrons and ions, said system comprising a source of electrons, a source of ions and an objective lens comprising first means including at least two electrodes for applying to the beam an electric field, and second means including one or more polepieces for applying to the beam a magnetic field, the electric and magnetic fields being adjusted in such a way as to cause the lens to focus both the ion and electron beams onto a common target plane coincident with the target.

2.      An optical system as claimed in claim 1 wherein said objective lens has three or more electrodes spaced apart along the optical axis and wherein the outermost electrodes are at the same potential so that the particles emerge from the lens with the same energy as that which they possessed when they entered the lens, and the inner electrode or electrodes are at a higher or lower potential.

3.      An optical system as claimed in claim 1 wherein said objective lens has three or more electrodes spaced apart along the optical axis and wherein the outermost electrodes are at different potentials so that the particles are subjected to a net acceleration or deceleration as they pass through the lens.

4.      An optical system as claimed in either one of claims 2 or 3 wherein the objective lens is a three-element einzel lens.

5.      An optical system as claimed in any one of claims 1 to 4 wherein at least one of said electrodes is made wholly or in part of ferromagnetic material so as to act as at least one of said magnetic polepieces forming part of said second means.

6.      An optical system as claimed in claim 5 wherein two of said electrodes double as polepieces in the manner aforsaid, said two electrodes being joined by a ferromagnetic circuit which forms the return path for magnetic flux and being at the same potential.

7. An optical system as claimed in claim 6 when appendant to either one of claims 2 or 4 wherein said two of said electrodes are the outermost electrodes and wherein the inner electrode is formed of non-magnetic material.

8. An optical system as claimed in claim 6 when appendant to either one of claims 2 or 4 wherein said two of said electrodes are the outermost electrodes and wherein the inner electrode is formed of ferromagnetic material.

9. An optical system as claimed in claim 5 wherein two of said electrodes double as polepieces in the manner aforsaid, said two electrodes being joined by a ferromagnetic circuit which forms the return path for magnetic flux, and being at different potentials, and wherein a gap or gaps is formed in said ferromagnetic circuit for the purpose of electrically isolating the two electrodes from each other.

10. An optical system as claimed in claim 9 when appendant to either one of claims 3 or 4 wherein said two of said electrodes are the inner electrode and one of the outer electrodes.

11. An optical system as claimed in claim 10 wherein said one of the outer electrodes is that outer electrode which is nearest to the target plane.

12. An optical system as claimed in claim 5 wherein said magnetic field is formed between two or more polepieces which together form one of said electrodes.

13. An optical system as claimed in claim 12 when appendant to any one of claims 2, 3 or 4 wherein said one of said electrodes is the innermost electrode.

14. A charged-particle optical system substantially as hereinbefore described with reference to Figures 2
to 5 of the accompanying drawings.

A

B

VI

+ ↑ ELECTRIC POTENTIAL ON AXIS

0

C

E

I

FIG.1

0150089

A

B

$V_I$

$+$

ELECTRIC
POTENTIAL
ON AXIS

$0$

C

AXIAL
MAGNETIC
FIELD
ON AXIS

E

I

4

D

FIG.2

0150089

FIG.3

0150089

FIG.4

FIG.5

## DOCUMENTS CONSIDERED TO BE RELEVANT

EP 85300210.3

| Category | Citation of document with indication. where appropriate, of relevant passages | Relevant to claim | CLASSIFICATION OF THE APPLICATION (Int. Cl.4) |
|---|---|---|---|
| X | US - A - 3 617 739 (LIEBL) <br> * Fig. 1-2; abstract; column 4, line 63 - column 5, line 23; claims 1,4-10 * | 1-4 | H 01 J 37/10 <br> H 01 J 27/00 |
| A | EP - A2 - 0 003 659 (HITACHI) <br> * Fig.; page 5, lines 1-14; claims 1-2,6 * | 1 | |
| A | EP - A2 - 0 093 868 (IBM) <br> * Fig. 2; page 4, lines 20-31; page 5, lines 4-21; claims 1-2 * | 1 | |

**TECHNICAL FIELDS SEARCHED (Int. Cl.4)**

H 01 J 37/00

H 01 J 27/00

H 01 J  3/00

H 01 J 49/00

The present search report has been drawn up for all claims

| Place of search | Date of completion of the search | Examiner |
|---|---|---|
| VIENNA | 05-04-1985 | BRUNNER |

EPO Form 1503 03 82